# EUROPEAN PATENT APPLICATION

(11) **EP 4 542 659 A1**
(43) Date of publication of application: **23.04.2025**
(21) Application number: 23822807.6
(22) Date of filing: 27.04.2023
(51) Int. Cl.: H01L 31/101, G02B 6/12

(54) **OPTICAL CHIP AND OPTICAL MODULE**

(30) Priority: 17.06.2022 CN 202210687471
(71) Applicant: Innolight Technology (Suzhou) Ltd., Suzhou, Jiangsu 215000 (CN)
(72) Inventor: WU, Hao, Suzhou, Jiangsu 215000 (CN); ZHENG, Xuezhe, Suzhou, Jiangsu 215000 (CN)
(74) Representative: Becker, Eberhard
(86) International application number: PCT/CN2023/091049
(87) International publication number: WO 2023/241236

(57) **Abstract**

An optical chip and an optical module. The optical chip includes: an optical device (100); an optical power detector (200), connected to the optical device (100); a waveguide (210), used for transmitting light emitted from the optical device (100); and a detection material (220), formed inside the waveguide (210) and/or on a surface of the waveguide (210). The detection material (220) absorbs light transmitted by the waveguide (210) and generates a preset effect, and the preset effect changes a preset parameter value of the detection material (220). The optical chip can simply and effectively integrate the optical power detector.

## Description

This application claims the priority benefit of China application serial no. 202210687471.9, filed on June 17, 2022 and entitled "OPTICAL CHIP AND OPTICAL MODULE", the entirety of the above-mentioned patent application is hereby incorporated by reference herein and made a part of this specification.

### Technical Field

The disclosure relates to the field of optoelectronic technology, and in particular to an optical chip and an optical module.

### Description of Related Art

With the development of the Internet, the emergence of massive content, and the deployment and application of 5G networks, the performance requirements for optical chips are increasing. On the same chip, integrating multiple optical devices on a single chip can effectively improve chip performance.

Optical power detectors are important devices for monitoring the power of various optical devices on optical chips, and their conventional structure usually includes semiconductor structures such as PIN junction and PN junction. Therefore, the integration of conventional optical power detectors on optical chips is relatively complicated, and even difficult to integrate on some optical chips.

### SUMMARY

### Technical Problems

Based on the above, the embodiments of the disclosure provide an optical chip capable of allowing an optical power detector to be easily and effectively integrated.

### Technical Solutions

An optical chip, including:
an optical device;
an optical power detector connected to the optical device and including:
   a waveguide used for transmitting light emitted from the optical device; and
   a detection material formed inside the waveguide and/or on a surface of the waveguide,
   the detection material absorbing light transmitted by the waveguide and generating a preset effect, and the preset effect changing a preset parameter value of the detection material.

In one of the embodiments, the optical device includes a lithium niobate device.

In one of the embodiments, the detection material includes a metal material.

In one of the embodiments, the preset effect includes a photothermal effect, and the preset parameter value includes resistance.

In one of the embodiments, the waveguide includes a core layer, an upper cladding layer, and a lower cladding layer, the core layer is located between the upper cladding layer and the lower cladding layer, and the detection material is located on an upper surface of the core layer and/or a lower surface of the core layer.

In one of the embodiments, the waveguide includes a core layer, an upper cladding layer, and a lower cladding layer, the core layer is located between the upper cladding layer and the lower cladding layer, and the detection material is located inside the upper cladding layer and/or inside the lower cladding layer.

In one of the embodiments, the waveguide includes a core layer, an upper cladding layer, and a lower cladding layer, the core layer and the detection material are both located between the upper cladding layer and the lower cladding layer, and the detection material is connected to the core layer.

In one of the embodiments, the waveguide includes a core layer, an upper cladding layer, and a lower cladding layer, the detection material includes a first detection portion, a second detection portion, a third detection portion, and a fourth detection portion, the first detection portion is located in the core layer, the fourth detection portion is located inside the upper cladding layer and/or the lower cladding layer, and the second detection portion and the third detection portion are connected between the first detection portion and the fourth detection portion.

In one of the embodiments, the waveguide includes a core layer, an upper cladding layer, and a lower cladding layer, the core layer is located between the upper cladding layer and the lower cladding layer, and the detection material is located on an upper surface of the upper cladding layer and/or a lower surface of the lower cladding layer.

An optical module includes the optical chip according to any one of the above.

### Beneficial Effects

In the optical chip and the optical module, the detection material generates the preset effect when exposed to light, so that the function of the optical power detector is effectively achieved. Further, the optical power detector only needs to form the detection material inside and/or on the surface of the waveguide. The waveguide acts as the carrier of the detection material and is able to be formed on various optical chips. The detection material (such as a metal material) itself is able to produce the preset effect when exposed to light and does not need to form a complex structure, and thus may be easily and effectively formed inside and/or on the surface of the waveguide through processes such as electroplating and deposition. Therefore, the optical chip provided by the disclosure is capable of allowing the optical power detector to be easily and effectively integrated.

### BRIEF DESCRIPTION OF THE DRAWINGS

To make the technical solutions provided in the embodiments of the disclosure or the related art more clearly illustrated, several accompanying drawings required by the embodiments or the related art for description are briefly introduced as follows. Obviously, the drawings in the following description are merely some embodiments of the disclosure, and for a person having ordinary skill in the art, other drawings can be obtained based on these drawings without an inventive effort.
FIG. 1 is a schematic structural diagram of an optical chip provided in one embodiment.
FIG. 2 to FIG. 10 are schematic structural diagrams of optical power detectors provided in different embodiments.

Description of Reference Numerals: 100- optical device, 200- optical power detector, 210- waveguide, 211- core layer, 212- upper cladding layer, 213- lower cladding layer, 220-detection material.

### DESCRIPTION OF THE EMBODIMENTS

To facilitate understanding of the disclosure, the disclosure will be described more comprehensively below with reference to the relevant accompanying drawings. The embodiments of the disclosure are illustrated in the accompanying drawings. However, the disclosure can be implemented in many different forms and is not limited to the embodiments described herein. On the contrary, the purpose of providing these embodiments is to make the disclosed content of the disclosure more thorough and comprehensive.

Unless otherwise defined, all technical and scientific terms used in the specification have the same meaning as commonly understood by a person having ordinary skill in the art. The terms used herein in the specification of the disclosure are for the purpose of describing specific embodiments only, and are not intended to limit the disclosure.

It shall be understood that when an element or a layer is referred to as being "on", "adjacent to", "connected to", or "coupled to" another element or layer, it means that the element or layer can be directly on, adjacent to, connected to, or coupled to another element or layer, or it means that an intervening element or layer may be present. In contrast, when an element is referred to as being "directly on", "directly adjacent to", "directly connected to", or "directly coupled to" another element or layer, it means that there is no intervening element or layer present.

It shall be understood that although the terms first, second, third, etc. may be used to describe various elements, components, regions, layers, doping types, and/or sections, these elements, components, regions, layers, doping types, and/or sections shall not be limited by these terms. These terms are only used to distinguish one element, component, region, layer, doping type, or section from another element, component, region, layer, doping type, or section. Therefore, a first element, component, region, layer, doping type, or section discussed in the following paragraphs could be termed a second element, component, region, layer, or section without departing from the teachings of the disclosure. For instance, a first doping type may become a second doping type, and similarly, the second doping type may become the first doping type. The first doping type and the second doping type are different doping types. For instance, the first doping type may be P type and the second doping type may be N type, or the first doping type may be N type and the second doping type may be P type.

Spatial relationship terms, such as "under", "below", "underlying", "beneath", "on", "above", etc., may be used herein to describe the relationship of one element or feature to other elements or features shown in the drawings. It should be understood that the spatially relative terms encompass different orientations of the device in use and operation in addition to the orientation depicted in the drawings. For instance, if the device in the drawings is turned over, elements or features described as "below", "under", or "beneath" other elements or features would then be oriented "above" the other elements or features. Therefore, the exemplary terms "below" and "under" may include both upper and lower orientations. In addition, the device may be otherwise oriented (e.g., rotated 90 degrees or at other orientations), and the spatial descriptors used herein are interpreted accordingly.

As used herein, the singular forms "a", "an", and "the" may include the plural forms as well, unless the context clearly dictates otherwise. It should also be understood that the terms "including/comprising" or "having" and the like designate the presence of stated features, integers, steps, operations, components, portions, or combinations thereof, but do not exclude the possibility of the presence or addition of one or more other features, integers, steps, operations, components, portions, or a combination thereof. Further, in the specification, the term "and/or" includes any and all combinations of the associated listed items.

As mentioned in the background section, the integration of conventional optical power detectors on optical chips is relatively complex, and even difficult to integrate on some optical chips.

To be specific, for instance, among many optical device solutions, thin-film lithium niobate devices are becoming one of the most favorable solutions for high-bandwidth optical devices due to their low loss, high modulation efficiency, high bandwidth, and high integration and have important applications in future high-speed optical modules.

At present, by integrating high-speed modulators, optical splitters, fiber couplers, and other devices into a single chip on the lithium niobate thin film, the functions required by the transmitter end of the optical device may be basically achieved. However, due to the particularity of its processing technology, lithium niobate material cannot be heterogeneously integrated with common semiconductor detector materials such as Ge, InP, and GaAs; therefore, as an important device for monitoring optical power and modulator working status, conventional and common optical power detectors cannot be well integrated on lithium niobate thin films.

Currently, there is a bonding method to heterogeneously integrate thin-film lithium niobate devices with detectors made of other materials. This heterogeneous integration can be at the chip level or the wafer level, but this method increases the complexity of the device, the process flow, and the production costs.

There are also coupling and packaging methods, in which the detectors used in the lithium niobate devices are integrated with the chip by grating coupling, edge coupling, and fiber coupling. However, this method requires precise coupling and packaging technology, which increases the complexity and costs of packaging.

The embodiments of the disclosure provide an optical chip capable of allowing an optical power detector to be easily and effectively integrated.

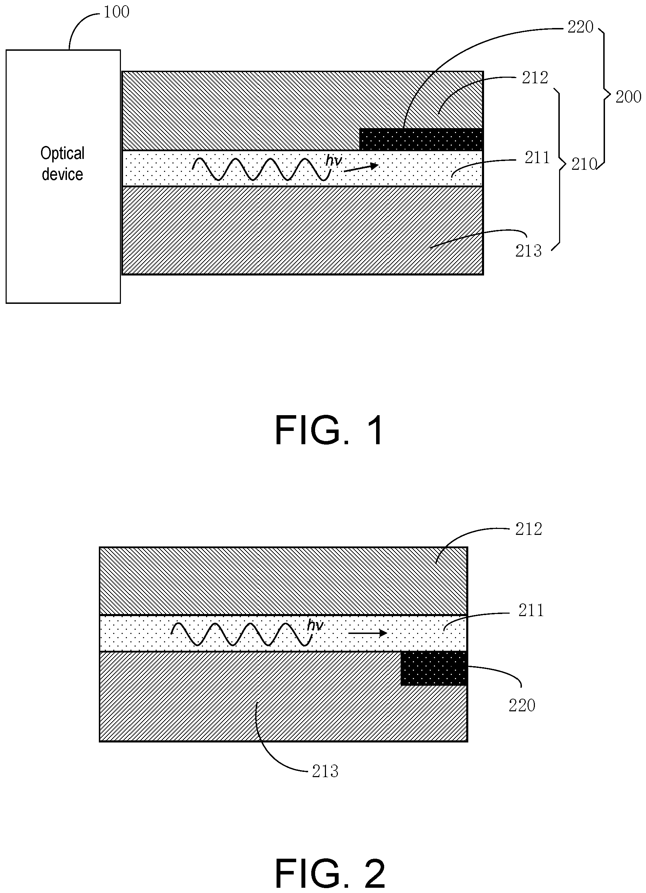

In an embodiment, with reference to FIG. 1, an optical chip including an optical device 100 and an optical power detector 200 is provided.

The optical device 100 may include but not limited to a lithium niobate device (e.g., a lithium niobate modulator). The lithium niobate device may be formed based on a lithium niobate thin film or a lithium niobate wafer. To be specific, relevant devices may be formed by performing various relevant process treatments such as patterning and diffusion on lithium niobate thin films or lithium niobate wafers.

The optical power detector 200 is connected to the optical device 100, so as to receive light emitted from the optical device 100.

Further, the optical power detector 200 includes a waveguide 210 and a detection material 220.

The waveguide 210 transmits the light emitted from the optical device 100. To be specific, the waveguide may include a core layer 211, an upper cladding layer 212, and a lower cladding layer 213. The core layer 211 is located between the upper cladding layer 212 and the lower cladding layer 213. As an example, the core layer 211 may be a lithium niobate core layer. The lithium niobate core layer has low optical power loss. Further, the lithium niobate core layer may be well connected to the lithium niobate device, so that a light beam emitted from the lithium niobate device may be well transmitted, and the optical power loss is lowered.

The detection material 220 is formed inside the waveguide 210 and/or on a surface of the waveguide 210. To be specific, the detection material 220 may be formed inside the waveguide 210, may be formed on the surface of the waveguide 210, or may be formed both inside the waveguide 210 and on the surface of the waveguide 210.

The detection material 220 absorbs light transmitted by the waveguide 210 and generates a preset effect, and the preset effect changes a preset parameter value of the detection material 220. Herein, the preset parameter of the detection material may be measured by an external testing device, so that optical power information transmitted by the waveguide 210 may be obtained through the change of the preset parameter value, and then optical power of the optical device 100 connected to the waveguide 210 may be monitored.

As an example, the detection material 220 may be a material that absorbs the communication bands O-Band (1260nm to 1360nm) and C-Band (including but not limited to metal materials, such as gold Au, titanium Ti, nickel Ni, aluminum Al, etc.)

As an example, the preset effect may include a photothermal effect, and the preset parameter value may include resistance.

To be specific, when some materials experience the photothermal effect, the photon energy interacts with the crystal lattice, intensifies vibrations, and increases temperature. An increase in temperature may cause a change in the resistance of a material. This type of material may be selected as a detection material.

Certainly, the preset effect is not limited to the photothermal effect, for example, it may also be a photoelectric effect.

Some metal materials absorb light with a frequency greater than a specific limit frequency, which can cause a photoelectric effect, and each metal has a corresponding limit frequency. When the photoelectric effect occurs, electrons inside the material are excited by photons to form an electric current, so the resistance of the material changes.

Certainly, the preset parameter is not limited to resistance. For instance, the preset effect may also be a photomagnetic effect, and in this case, the preset parameter may also be the magnetization intensity.

Some non-magnetic materials show magnetization intensity (photomagnetic effect) under the action of light. This type of material may be selected as a detection material.

In this embodiment, the detection material 220 generates the preset effect when exposed to light, so that the function of the optical power detector can be effectively achieved.

Further, the optical power detector of this embodiment only needs to form the detection material 220 inside and/or on the surface of the waveguide 210. The waveguide 210 acts as a carrier of the detection material and may be formed on various optical chips. The detection material 220 (such as a metal material) itself can produce the preset effect when exposed to light and does not need to form a complex structure, and thus may be easily and effectively formed inside and/or on the surface of the waveguide 210 through processes such as electroplating and deposition. Therefore, the optical chip provided by this embodiment is capable of allowing the optical power detector to be easily and effectively integrated.

In one embodiment, with reference to FIG. 1 or FIG. 2, the waveguide 210 includes the core layer 211, the upper cladding layer 212, and the lower cladding layer 213. The core layer 211 is located between the upper cladding layer 212 and the lower cladding layer 213. The detection material 200 is located on an upper surface of the core layer 211 and/or a lower surface of the core layer 211.

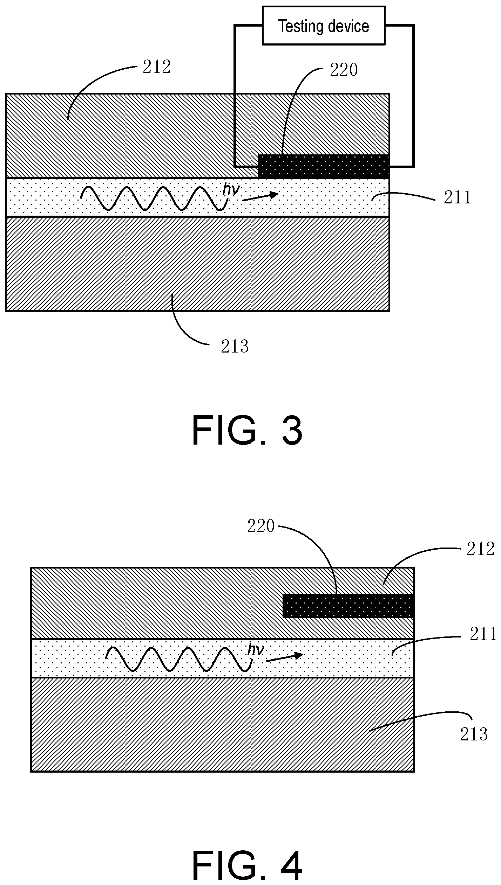

Herein, with reference to FIG. 3, after light transmitted in the core layer 211 (e.g., a lithium niobate core layer) contacts the detection material 220, it is absorbed, so that the preset parameter value of the detection material changes. By measuring the change of the preset parameter value of the detection material through an external testing device, the optical power information transmitted by the waveguide 210 may be obtained, and then the optical power of the optical device 100 connected to the waveguide 210 may be monitored.

To be specific, with reference to FIG. 1, the detection material 220 may be located on the upper surface of the core layer 211. Herein, as an example, during a chip processing and manufacturing process, after the core layer 211 is formed, the detection material 220 may be formed on its upper surface by electroplating, deposition, or other processes.

Alternatively, with reference to FIG. 2, the detection material 220 may also be located on the lower surface of the core layer 211. Herein, as an example, during the chip processing and manufacturing process, after the lower cladding layer 213 is formed, the lower cladding layer may be patterned to form a groove. The groove is then filled with the detection material 220. The core layer 211 is then formed, so that the detection material is located on the lower surface of the core layer 211.

Alternatively, the detection material 220 may also be located on both the upper surface and the lower surface of the core layer 211. Herein, two sets of testing devices may be designed externally to test the preset parameter values of the detection material 220 located on the upper surface of the core layer 211 and the detection material 220 located on the lower surface of the core layer 211 respectively, so as to verify the detection results mutually and improve the detection accuracy.

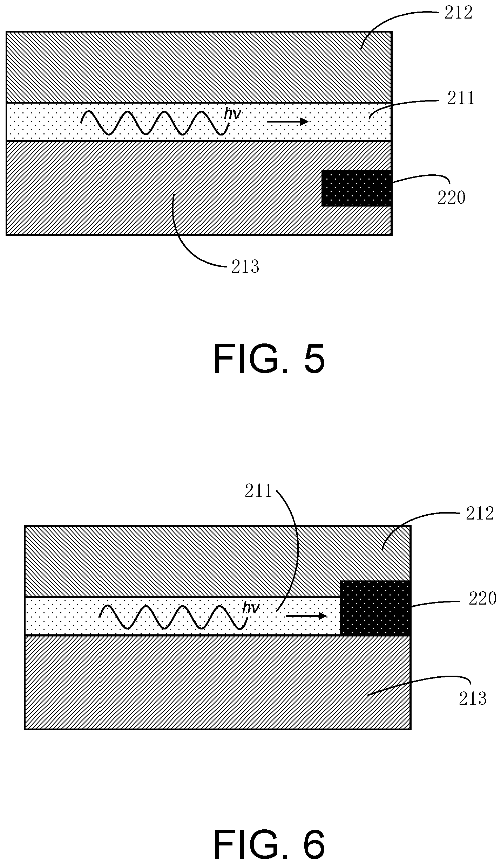

In one embodiment, with reference to FIG. 4 or FIG. 5, the waveguide includes the core layer 211, the upper cladding layer 212, and the lower cladding layer 213. The core layer 211 is located between the upper cladding layer 212 and the lower cladding layer 213. The detection material 220 is located inside the upper cladding layer 212 and/or inside the lower cladding layer 213.

Herein, after the light transmitted in the core layer 211 (e.g., a lithium niobate core layer) enters a region opposite to the detection material 220, it is absorbed by an evanescent wave effect, so that the preset parameter value of the detection material 220 changes. By measuring the change of the preset parameter value of the detection material through an external testing device, the optical power information transmitted by the waveguide 210 may be obtained, and then the optical power of the optical device 100 connected to the waveguide 210 may be monitored.

To be specific, with reference to FIG. 4, the detection material 220 may be located inside the upper cladding layer 212. Herein, as an example, the upper cladding layer 212 may include at least two sub-layers. To be specific, during the chip processing and manufacturing process, an upper cladding sub-layer may be formed first, and then the upper cladding sub-layer may be patterned to form a groove. The groove is then filled with the detection material 220. Another upper cladding sub-layer is then formed, so that the detection material is located inside the upper cladding layer 212.

Alternatively, with reference to FIG. 5, the detection material 220 may also be located inside the lower cladding layer 213. Herein, as an example, the lower cladding layer 213 may include at least two sub-layers. To be specific, during the chip processing and manufacturing process, a lower cladding sub-layer may be formed first, and then the upper cladding sub-layer may be patterned to form a groove. The groove is then filled with the detection material 220. Another lower cladding sub-layer is then formed, so that the detection material is located inside the lower cladding layer 213.

Alternatively, the detection material 220 may also be located on the upper cladding layer 212 and inside the lower cladding layer 213. Herein, two sets of testing devices may be designed externally to test the preset parameter values of the detection material 220 located on the upper cladding layer 212 and the detection material 220 located inside the lower cladding layer 213 respectively, so as to verify the detection results mutually and improve the detection accuracy.

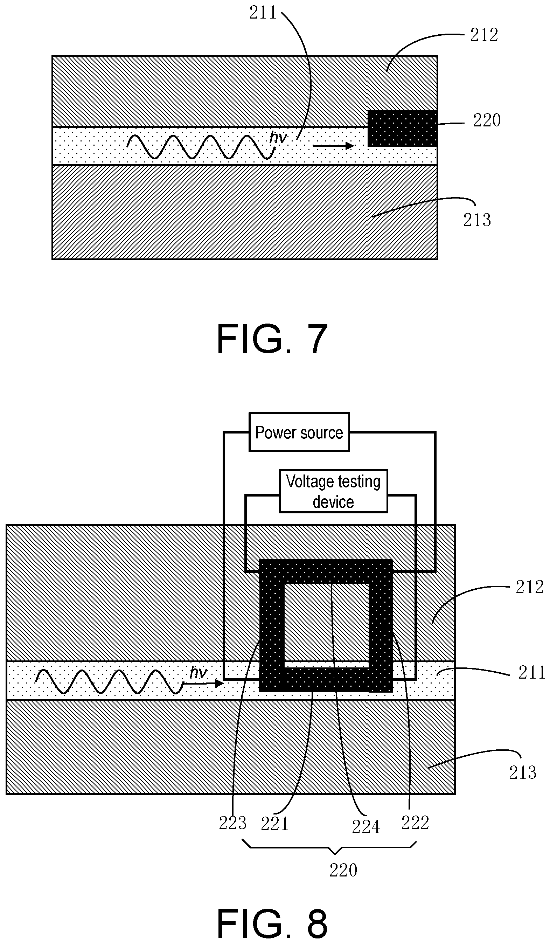

In one embodiment, with reference to FIG. 6 or FIG. 7, the waveguide 210 includes the core layer 211, the upper cladding layer 212, and the lower cladding layer 213. The core layer 211 is located between the upper cladding layer 212 and the lower cladding layer 213. Further, the detection material 220 is also located between the upper cladding layer 212 and the lower cladding layer 213, and the detection material 220 is connected to the core layer 211.

Herein, the light transmitted in the core layer 211 (e.g., a lithium niobate core layer) can directly enter the detection material through an end surface of the core layer 211 and be absorbed, so that the preset parameter value of the detection material changes. By measuring the change of the preset parameter value of the detection material through an external testing device, the optical power information transmitted by the waveguide 210 may be obtained, and then the optical power of the optical device 100 connected to the waveguide 210 may be monitored.

Herein, as an example, with reference to FIG. 6, during the chip processing and manufacturing process, after the lower cladding layer 213 is formed, the core layer 211 may be formed on a partial region of the surface of the lower cladding layer 213, and then the detection material 220 may be formed in a region without the core layer.

Alternatively, as an example, with reference to FIG. 7, during the chip processing and manufacturing process, the core layer 211 may be formed after the lower cladding layer 213 is formed. A groove is then formed on the core layer 211, and then the detection material 220 is filled in the groove. Herein, a contact area between the detection material 220 and the core layer 211 may be effectively increased, so absorption increases. To be specific, an upper surface of the detection material 220 may be flush with the upper surface of the core layer 211, higher than the upper surface of the core layer 211, or lower than the upper surface of the core layer 211, which is not particularly limited herein.

In one embodiment, with reference to FIG. 8, the waveguide includes the core layer 211, the upper cladding layer 212, and the lower cladding layer 213. The core layer 211 is located between the upper cladding layer 212 and the lower cladding layer 213. The detection material 220 includes a first detection portion 221, a second detection portion 222, a third detection portion 223, and a fourth detection portion 224. The first detection portion is located in the core layer 211, and the fourth detection portion 224 is located inside the upper cladding layer 212 and/or the lower cladding layer 213. The second detection portion 222 and the third detection portion 223 are connected between the first detection portion 221 and the fourth detection portion 224.

Herein, the first detection portion 221, the second detection portion 222, the third detection portion 223, and the fourth detection portion 224 may form a Wheatstone bridge. Two diagonal ends of a quadrilateral formed by the first detection portion 221, the second detection portion 222, the third detection portion 223, and the fourth detection portion 224 may be connected to an external power source, and two diagonal ends of the other diagonal may be connected to a voltage testing device. When no light is transmitted in the waveguide 210, the voltage measured by the voltage testing device may be 0V, and when light of different powers enters the waveguide 210, the preset parameter values (e.g., resistance values) of each detection portion change to varying degrees. As a result, the voltages measured by the voltage testing device are different, so that the optical power may be monitored.

In the above embodiments, the detection material 200 is located on an upper surface of the core layer 211 and/or a lower surface of the core layer 211. Alternatively, the detection material 220 is located inside the upper cladding layer 212 and/or inside the lower cladding layer 213. Alternatively, the detection material 220 is also located between the upper cladding layer 212 and the lower cladding layer 213, and the detection material 220 is connected to the core layer 211. Alternatively, the detection material 220 includes the first detection portion 221, the second detection portion 222, the third detection portion 223, and the fourth detection portion 224. The above are all exemplary embodiments in which the detection material 220 is located inside the waveguide 210. When the detection material 220 is located inside the waveguide 210, a signal on the detection material 220 may be led out, and holes may be drilled to leak out the detection material. The holes are then filled with a conductive material to form a conductive connection structure to connect the detection material and the external testing device.

It can be understood that the form in which the detection material 220 is located inside the waveguide 210 is not limited to this, and it can also be in other forms. Further, the detection material 220 is not limited to being located inside the waveguide 210, it can also be located on the surface of the waveguide.

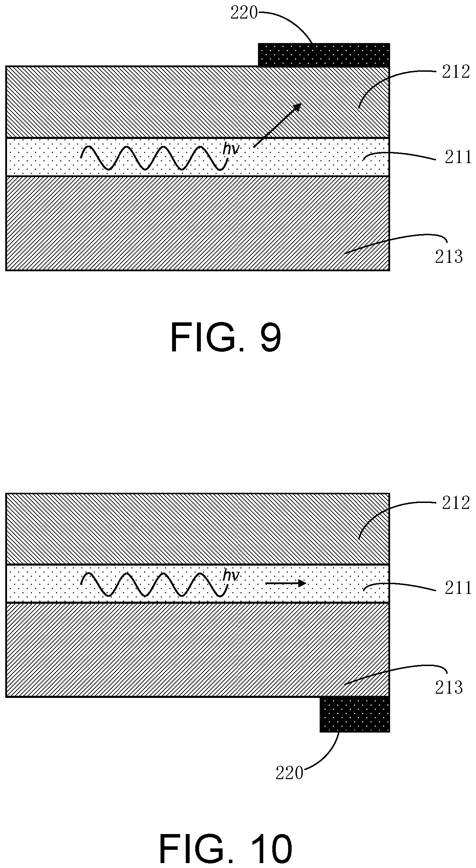

In one embodiment, with reference to FIG. 9 or FIG. 10, the waveguide includes the core layer 211, the upper cladding layer 212, and the lower cladding layer 213. The core layer 211 is located between the upper cladding layer 212 and the lower cladding layer 213. The detection material is located on the upper surface of the upper cladding layer and/or the lower surface of the lower cladding layer.

Herein, after the light transmitted in the core layer 211 (e.g., a lithium niobate core layer) enters the region opposite to the detection material 220, it is absorbed by the evanescent wave effect, so that the preset parameter value of the detection material 220 changes. By measuring the change of the preset parameter value of the detection material through an external testing device, the optical power information transmitted by the waveguide 210 may be obtained, and then the optical power of the optical device 100 connected to the waveguide 210 may be monitored.

To be specific, with reference to FIG. 9, the detection material 220 may be located on the upper surface of the upper cladding layer 212. Herein, as an example, during the chip processing and manufacturing process, after the upper cladding layer 212 is formed, the detection material 220 may be formed on its upper surface by electroplating, deposition, or other processes.

Alternatively, with reference to FIG. 10, the detection material 220 may also be located on the lower surface of the lower cladding layer 213. Herein, as an example, during the chip processing and manufacturing process, the detection material 220 may be formed before the lower cladding layer 213 is formed, and then the lower cladding layer 213 covering the detection material 220 may be formed, so that the detection material is located on the lower surface of the lower cladding layer 213.

In one embodiment, an optical module is provided, and the optical module includes the optical chip according to any one of the above. In addition, the optical module may also include an electrical module, a control board, a printed circuit board, etc.

In the description of the specification, descriptions with reference to the terms such as "one embodiment", "other embodiments", etc. means that a particular feature, structure, material, or characteristic described in connection with the embodiment or example is included in at least one embodiment or example of the disclosure. In the specification, the schematic description of the above-mentioned terms does not necessarily refer to the same embodiment or example.

The technical features of the above-described embodiments may be combined arbitrarily. In order to simplify the description, not all possible combinations of the technical features in the above embodiments are described. However, as long as there is no contradiction in the combinations of these technical features, these combinations should be considered to be within the scope of the description in this specification.

The abovementioned embodiments only represent several embodiments of the disclosure, and the descriptions thereof are specific and detailed, but should not be construed as a limitation on the scope of the invention patent. It should be pointed out that for a person having ordinary skill in the art, without departing from the concept of the disclosure, several modifications and improvements can be made, which all belong to the protection scope of the disclosure. Therefore, the protection scope of the patent of the disclosure should be subject to the appended claims.

## Claims

1. An optical chip, **characterized in** comprising:
an optical device; and
an optical power detector connected to the optical device and comprising:
a waveguide used for transmitting light emitted from the optical device; and
a detection material formed inside the waveguide and/or on a surface of the waveguide,
the detection material absorbing light transmitted by the waveguide and generating a preset effect, and the preset effect changing a preset parameter value of the detection material.

2. The optical chip according to claim 1, **characterized in that** the optical device comprises a lithium niobate device.

3. The optical chip according to claim 1, **characterized in that** the detection material comprises a metal material.

4. The optical chip according to claim 1, **characterized in that** the preset effect comprises a photothermal effect, and the preset parameter value comprises resistance.

5. The optical chip according to claim 1, **characterized in that** the waveguide comprises a core layer, an upper cladding layer, and a lower cladding layer, the core layer is located between the upper cladding layer and the lower cladding layer, and the detection material is located on an upper surface of the core layer and/or a lower surface of the core layer.

6. The optical chip according to claim 1, **characterized in that** the waveguide comprises a core layer, an upper cladding layer, and a lower cladding layer, the core layer is located between the upper cladding layer and the lower cladding layer, and the detection material is located inside the upper cladding layer and/or inside the lower cladding layer.

7. The optical chip according to claim 1, **characterized in that** the waveguide comprises a core layer, an upper cladding layer, and a lower cladding layer, the core layer and the detection material are both located between the upper cladding layer and the lower cladding layer, and the detection material is connected to the core layer.

8. The optical chip according to claim 1, **characterized in that** the waveguide comprises a core layer, an upper cladding layer, and a lower cladding layer, the detection material comprises a first detection portion, a second detection portion, a third detection portion, and a fourth detection portion, the first detection portion is located in the core layer, the fourth detection portion is located inside the upper cladding layer and/or the lower cladding layer, and the second detection portion and the third detection portion are connected between the first detection portion and the fourth detection portion.

9. The optical chip according to claim 1, **characterized in that** the waveguide comprises a core layer, an upper cladding layer, and a lower cladding layer, the core layer is located between the upper cladding layer and the lower cladding layer, and the detection material is located on an upper surface of the upper cladding layer and/or a lower surface of the lower cladding layer.

10. An optical module, **characterized in** comprising the optical chip according to claim 1.
